# EUROPEAN PATENT SPECIFICATION

(11) **EP 1 651 802 B1**
(45) Date of publication and mention of the grant of the patent: **09.03.2011**
(21) Application number: 04745167.9
(22) Date of filing: 09.06.2004
(51) Int. Cl.: C30B 25/12, C23C 16/458

(54) **SUPPORT SYSTEM FOR TREATMENT APPARATUSES**
HALTERUNGSSYSTEM FÜR BEHANDLUNGSAPPARATUREN
SYSTEME DE SUPPORT POUR APPAREILS DE TRAITEMENT

(43) Date of publication of application: 03.05.2006
(73) Proprietor: E.T.C. Epitaxial Technology Center SRL, 95127 Catania (IT)
(72) Inventor: Speciale Natale, I-91020 Mazara del Vallo, Trapani (IT); VALENTE, Gianluca, I-20127 Milano (IT); CRIPPA, Danilo, I-28100 Novara (IT); POZZETTI, Vittorio, I-20047 Brugherio (IT); PRETI, Franco, I-20133 Milano (IT)
(74) Representative: Dragotti, Gianfranco
(86) International application number: PCT/IT2004/000335
(87) International publication number: WO 2005/121417

(56) References cited:
- WO-A-03/069029
- WO-A-2004/053188
- US-A- 4 593 168
- US-A- 4 860 687
- US-A- 5 788 777
- US-A1- 2003 188 687
- US-A1- 2003 233 768

## Description

The present invention relates to a support system for an apparatus of the type designed to treat substrates and/or wafers in accordance with the preamble of Claim 1.

In order to produce integrated circuits or electronic and optoelectronic components it is required to treat substrates and/or wafers; the latter may be made of a single material (semiconductor or insulator) or several materials (conductor, semiconductor and insulator); the term "substrate" and the term "wafer" in practice often refer to the same thing, namely a thin element which is generally disc-shaped (in solar cells it is square); usually the first term is used when the element basically has the function of solely supporting layers or structures of semiconductor material, while the second term is used in all other cases.

The forms of treatment which exist include purely thermal treatment and chemical/physical treatment using heat; epitaxial growth is the most common chemical/physical treatment.

Generally, in order to perform the epitaxial growth of semiconductor materials (Si, Ge, SiGe, GaAs, AlN, GaN, SiC, etc.) on substrates, high temperatures are necessary if it is required that the quality of the grown material should be suitable for electronic applications. In the case of semiconductor materials such as silicon, temperatures which typically range from 1000°C to 1200°C are used. In the case of semiconductor materials such as silicon carbide, even higher temperatures are required; in particular, in the case of silicon carbide, temperatures which typically range from 1500°C to 1800°C are used. The growth process, during which a high temperature is maintained, generally lasts several tens of minute.

A reactor for performing epitaxial growth of silicon carbide or similar material therefore requires, among other things, a system which generates heat so as to be able to achieve these temperatures inside a reaction chamber; obviously, it is desirable that the system should generate heat not only in an effective manner, but also efficiently. For these reasons, in these types of reactors, hot-wall reaction chambers are used.

One of the methods most suited for heating the walls of a reaction chamber is that based on electromagnetic induction, which envisages an element made of conductor material, an inductor and an alternating electric current (having a frequency typically between 2 KHz and 20 KHz); the electric current is made to flow inside the inductor so as to generate a variable magnetic field and the element is positioned so that it is enveloped by the variable magnetic field; the electric currents induced in the element as a result of the variable magnetic field cause heating of the element owing to the Joule effect; such a heating element is a so-called susceptor and may also be used directly as a wall of the reaction chamber if suitable materials are used.

Induction heating is very common also in cold-wall reactors; in this case the element heated by means of induction is the substrate support.

An epitaxial growth reactor also requires that the reaction chamber be thermally isolated from the external environment, in particular in order to limit the heat losses, and well sealed in order to prevent, on the one hand, the reaction gases from being dispersed and contaminating the external environment and, on the other hand, the gases of the external environment from penetrating and contaminating the internal reaction environment.

In apparatus for the treatment of substrates and/or wafers and, in particular, in epitaxial reactors it is practically indispensable to cause rotation or the substrate and/or wafer support; generally, this rotation is performed by means of a motorized apparatus which is situated outside the treatment chamber and which imparts a rotary movement to the support by means of suitable transmission means. In particular, in the case of epitaxial reactors, the speed of rotation of the support is always within the interval ranging from 1 rpm to 100 rpm and is generally between 5 rpm and 25 rpm.

This method of rotation functions well, but has the disadvantage that it requires either transmission means able to withstand the environment of the treatment chamber or sealing means which allow the transmission of a rotary movement, or both things; these requirements are even more difficult to satisfy in the case of reactors for the growth of materials such as silicon carbide, owing to the very high temperatures.

In order to solve this problem, in the past it was thought to use a different method of rotation based on the use of gas flows.

The patent US 4,667,076 discloses an apparatus for the heat treatment of wafers; in this apparatus the wafer is lifted from its seat directly by gas flows, is kept suspended in the atmosphere of the treatment chamber directly by the gas flows, is made to rotate directly by the gas flows which are suitably directed and is heated by means of microwave irradiation.

The patent US 4,860,687 discloses rotating support systems for epitaxial reactors which envisage a plurality (not less than three) gas flows for raising directly a disc-shaped susceptor (namely a movable support element for substrates and/or wafers) from a flat surface (of a base element); one or more gas flows are used directly in order to cause rotation of the susceptor; the gas travels along channels (narrow and long passages which are open on one side) and therefore cause rotation of the susceptor as a result of the fluid-dynamic driving effect; the channels are typically formed in the base element, but may also be formed in the susceptor,

The patent US 5,788,777 discloses a rotating support system for epitaxial reactors comprising a disc-shaped support structure which is made to rotate by a motorized apparatus with cavities for housing four disc-shaped support elements; US 2003/233768 discloses a support system for treating wafers in a CVD reactor, having passages through which a gas flows to support and lift the movable support element. These passages are inclined and skew with respect to the rotation axis.

In turn WO 03/069029 discloses a support element having a bottom side provided with depressed areas having various geometrical shapes including a depth which varies in the radial direction.

Lastly WO 2004/053188discloses a supporting system for an apparatus for treating substrates and wafers each of the support elements is kept raised by two vertical gas flows and rotates about its axis since the entire support structure rotates.

The object of the present invention is generally that of providing a rotating support system which is different from and/or better than those already known.

This object is achieved by the support system for a treatment apparatus having the characteristing features recited in independent Claim 1.

The idea underlying the present invention is that of using a fixed base element which is provided with a cylindrical seat, housing a movable disc-shaped support element inside the seat, and using one or more inclined gas flows both in order to lift the support element and in order to cause, rotation thereof by taking advantage of shaped depressed areas in the bottom side of the support element.

Further advantageous features of the present invention are recited in the dependent claims.

The support system according to the present invention achieves excellent results by means of a suitable support element.

The present invention relates, finally, to an epitaxial growth reactor and to a thermal treatment apparatus having respectively the characteristing features in independent Claims 19 and 20, in which the support system according to the present invention may be advantageously employed.

The present invention will become clearer from the following description to be considered in conjunction with the accompanying drawings that are exemplary and therefore not limiting, in which:
Fig. 1 shows various views of a support system according to the present intention;
Fig. 2 shows a reaction chamber of an epitaxial reactor according to the present invention which incorporates the support system according to Fig. 1;
Fig. 3 shows, viewed from below, a support element according to the present invention provided with depressed areas having different shapes;
Fig. 4 shows, viewed from below, a support element according to the present invention provided with eight depressed areas having the same shape;
Fig. 5 shows a schematic drawing illustrating the principle on which rotation of the support system according to the present invention is based;
Fig. 6 is a schematic drawing illustrating the principle on which operation of the depressed areas according to the present invention is based; and
Fig. 7 is a cross-sectional view of a detail of the support system according to Fig. 1.

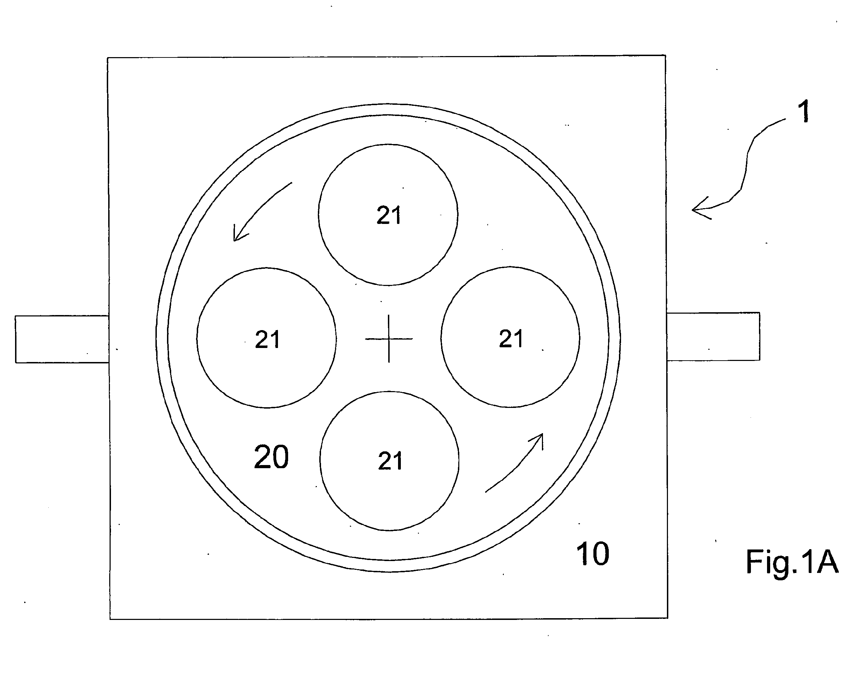

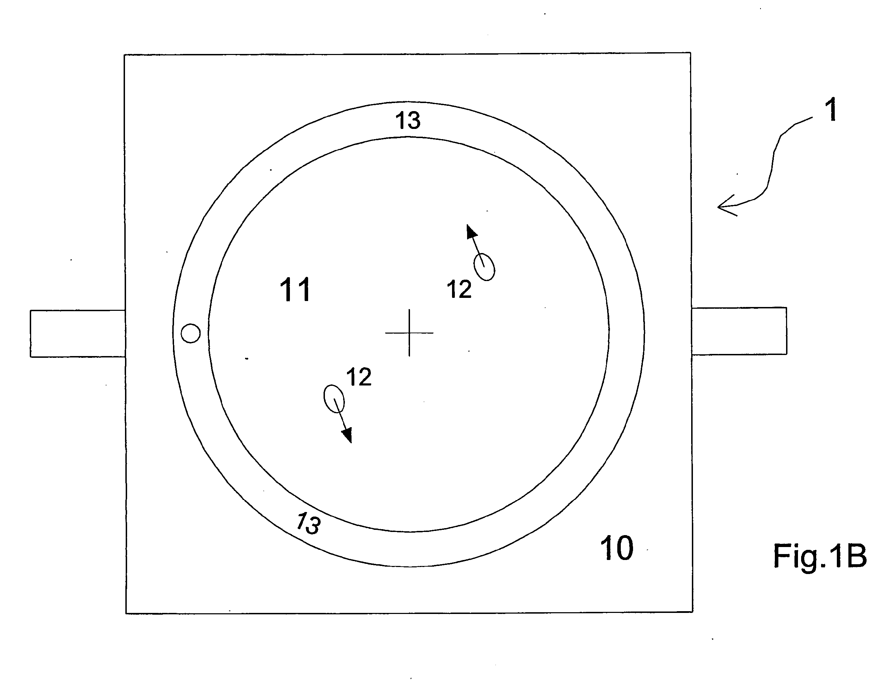

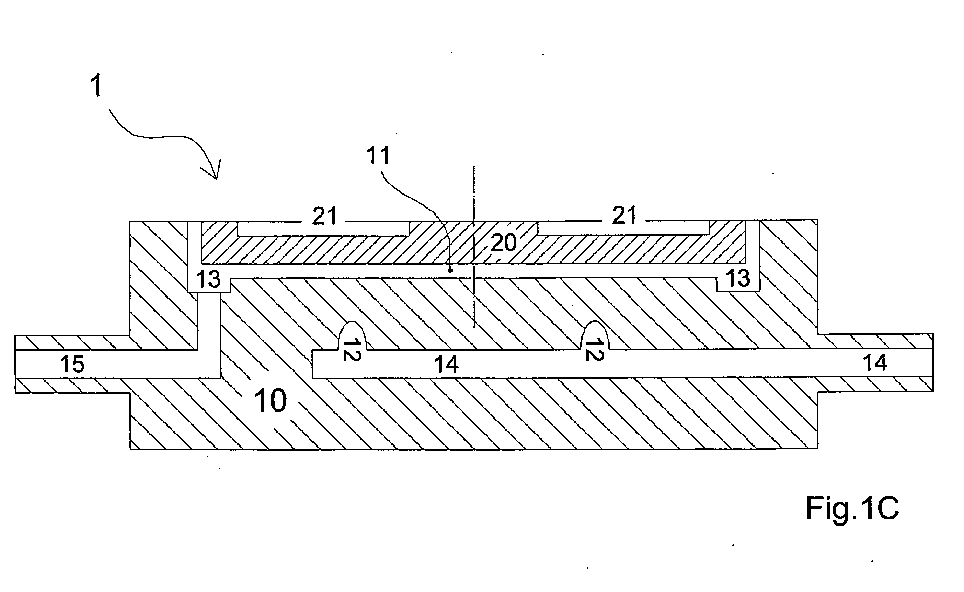

Fig. 1 shows, schematically, an embodiment of a support system according to the present invention which is basically composed of a base element and a support element; in particular, Fig. 1A is a top plan view of the complete system, Fig. 1B is a top plan view of the system without the support element and Fig. 1C is a cross-sectional view of the complete system.

In Fig. 1 the support system is denoted overall by the reference number 1, the base element by the reference number 10 and the support element by the reference number 20.

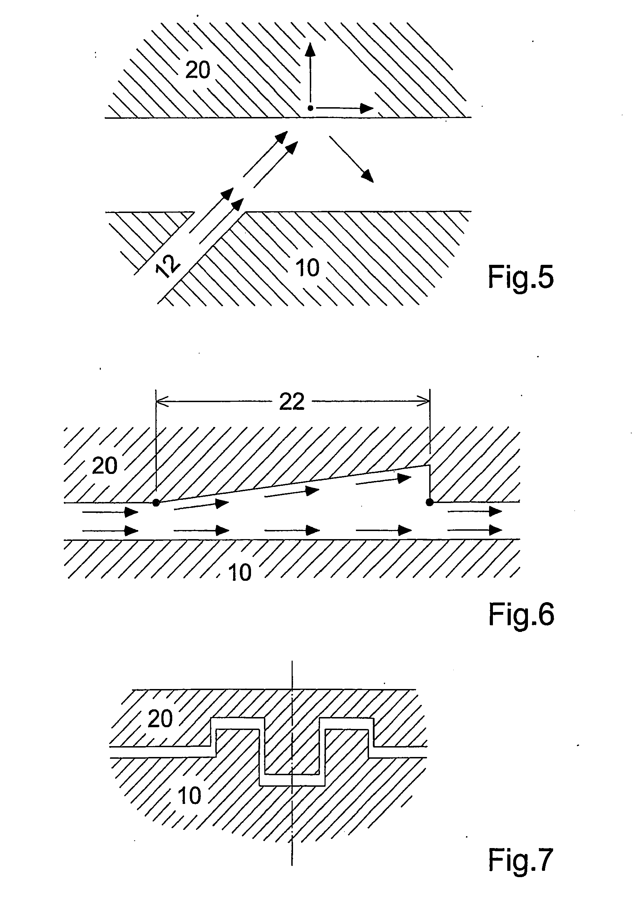

The base element 10 is fixed and has a flat surface in which a cylindrical seat 11 is formed; the base element 10 is positioned so that its flat surface is horizontal (as can be seen from the figures); the bottom of this seat is flat but has some recesses and protuberances which will be explained below also with the aid of Fig. 7.

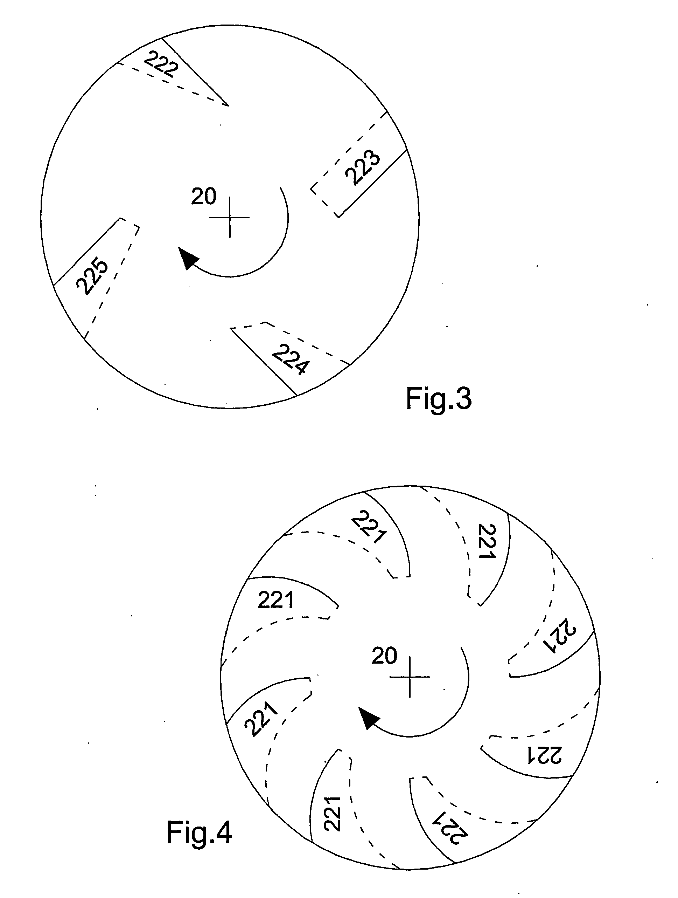

The support element 20 has a disc-shaped form with an upper side which is flat, but has four cavities 21, and with a bottom side which is flat, but has some recesses and protuberances which will be clarified below also with the aid of Fig. 3, Fig. 4 and Fig. 7; the four cavities 21 are intended for four substrates or wafers; the element 20 is housed inside the seat 11 and is able to rotate about the axis of the seat 11.

A pipe 14 is formed inside the base element 10 and branches out into two passages 12 which emerge inside the seat 11 in a middle zone between the centre and the edge of the seat 11 (about halfway); the passages 12 are inclined with respect to the axis of the seat 11 at 40° (relative to the vertical) and more precisely are skew; the pipe 14 is designed to be fed with gas (supplied form outside the rotating system) so that the two gas flows emerge from the two passages 12 in directions which are inclined with respect to the axis of the seat 11; in Fig. 1B, the two gas flows emerging from the passages 12 are indicated schematically by two arrows.

Inside the seat 11, more precisely on the bottom thereof, a peripheral annular channel 13 is formed, said channel being designed to collect the gas emitted from the passages 12; the channel 13 communicates with a pipe 15 for evacuating the gas from the passages 12 outside the rotating system.

The structure described above is designed so that substantially all the gas which flows inside the pipe 14 also flows into the pipe 15; this means that only a small amount of gas flows inside the gap defined between the outer edge of the element 20 and the inner edge of the seat 11; this effect is due to the fact that the difference between the size of their diameters is small.

In the embodiment shown in Fig. 1, the element 20 has a diameter of about 190 mm and a thickness of about 4 mm; the seat 11 has a diameter of about 196 mm (6 mm greater than the diameter of the element 20) and a depth of about 4.6 mm (0.6 mm greater than the thickness of the element 20); there are four cavities with a size of 2.5 inches, equivalent to about 63 mm (inches are the units of measurement universally used for wafers and substrates in the microelectronics sector).

In the embodiment according to Fig. 1, the support element has a weight of 250-300 g (the additional weight of the substrates or wafers ranges from a few grammes to several grammes depending on the material and the diameter); using a support element having a bottom side which is perfectly flat and supplying the pipe 14 with a hydrogen flow at a rate of 10 slm (standard litres per minute), a speed of about 10 rpm was obtained; Fig. 1A shows the direction of rotation of the element 20 produced by the two gas flows emerging from the passages 12 in the directions indicated in Fig. 1B.

Variations to the embodiment shown in Fig. 1 may envisage, for example, thicknesses of the element 20 ranging between 3 mm and 5 mm, differences between the diameter of the seat 11 and the diameter of the µelement 20 ranging between 4 mm and 10 mm, differences between the depth of the seat 11 and the thickness of the element 20 ranging between 0.4 mm and 1.0 mm, angles of inclination of the passages 21 ranging between 35° and 45° (relative to the vertical); using an element 20 with a diameter of 190 mm it is possible to envisage alternatively a single 6-inch cavity, three 3-inch cavities, four 2.5-inch cavities or six 2-inch cavities. As regards the rotating gas, as an alternative to hydrogen, it is possible to use helium or argon; the rate of flow of the rotating gas may be chosen in the range of 5 slm to 20 slm or more, but avoiding excessively high flow rates which cause vibration of the element 20 during rotation.

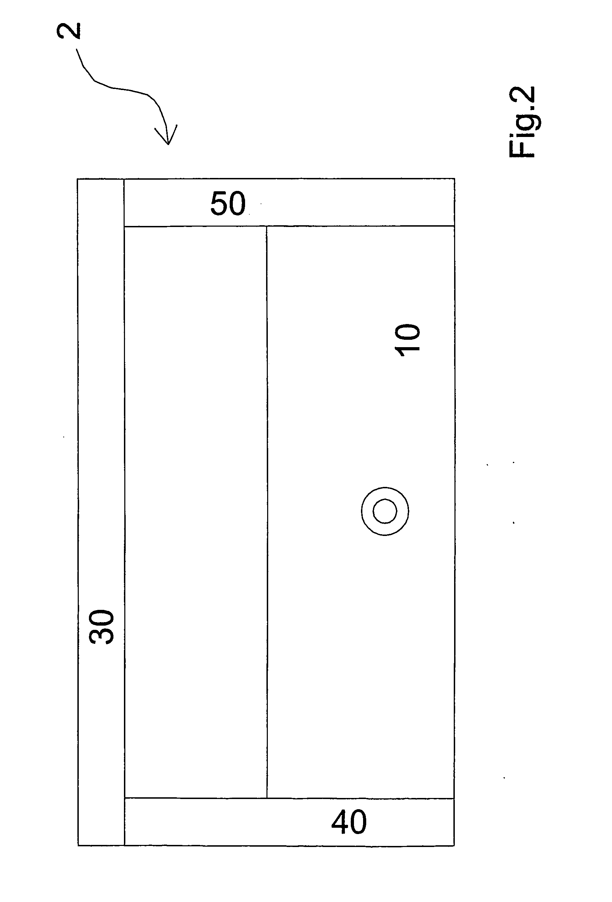

Fig. 2 shows a front view of a reaction chamber of an epitaxial reactor according to the present invention which incorporates the support system according to Fig. 1; this chamber is denoted overall by the reference number 2; the base element 10 acts as a bottom wall of the chamber; the chamber also comprises a top wall 30, a first (left-hand) side wall 40, a second (right-hand) side wall 50; the chamber according to Fig. 2 is of the hot-wall type; the four walls are made of graphite coated - at least internally towards the enclosed space of the reaction chamber - with a protective layer for example of silicon carbide or tantalum carbide.

With reference to Fig. 7, a cylindrical protuberance with a cylindrical hole is provided in the centre of the seat 11 of the base element 10 and a cylindrical recess with a cylindrical pin is provided in the centre of the bottom side of the support element 20; the pin of the support element is inserted inside the hole of the base element and the protuberance of the base element is inserted inside the recess of the support element; as can be noted from the Figure, the length of the pin is greater than the depth of the recess (about double); this structure is not shown in any of the above figures, in particular in Fig. 1, so that they are easier to understand.

In the embodiment according to Fig. 7, the recess in the element 20 has a diameter of about 12.5 mm and a depth of about 2 mm, the pin of the element 20 has a diameter of about 2.5 mm and a length of about 4 mm; the dimensions of the protuberance and the hole of the element 10 differ slightly from the corresponding dimensions of the element 20, in particular as regards the diameters, for example by 0.5 mm or 0.4 mm or even less.

The structure according to Fig. 7 has the function of guiding rotation of the support element 20 inside the seat 11.

The bottom side of the support element 20 shown in Fig. 1 is provided with depressed areas denoted generally by the reference number 22; Fig. 3 shows, viewed from underneath, the bottom side of a support element 20 with four depressed areas 222, 223, 224 and 225 having different shapes, while Fig. 4 shows, viewed from the underneath, the bottom side of a support element 20 with eight depressed areas 221 which are all identical, in particular having the same shape, and are arranged symmetrically with respect to the axis of the support element 20. For the sake of clarity, it is worth noting that Fig. 3 is intended to show various possible shapes of the depressed areas, but the support elements according to the present invention generally have depressed areas with the same shape.

The depressed areas 22 have the function of improving the rotation of the support element 20 inside the seat 11; in particular, they are able to obtain a greater speed of rotation for the same gas flow (compared to the case where there are no depressed areas and therefore rotation is due solely to the inclined passages 12).

In the embodiment according to Fig. 1, the support element has a weight of 250-300 g (the additional weight of the substrates or wafers ranges from a few grammes to several grammes depending on the material and the diameter); using a support element with a bottom side having depressed areas of varying shape and supplying the pipe 14 with a hydrogen flow at a rate of 10 slm (standard litres per minute), speeds ranging between 15 rpm and 30 rpm were obtained; Fig. 3 and

Fig. 4 show the direction of rotation of the element 20 produced by the two gas flows emerging from the passages 12 in the directions shown in Fig. 1B.

Some embodiments of the depressed areas according to the present invention will be illustrated below with reference to Fig. 3 and Fig. 4.

The area 221 is bounded by four sides; all the sides are curved; one of the sides corresponds to a long section of the edge of the bottom side of the support element; one of the sides is a short circumferential section having a centre coinciding substantially with the axis of the support element; the other two sides extend in the radial direction and reach the edge of the bottom side of the support element; this area is wider in the peripheral zone than in the central zone.

In the case of the example 221, the depressed area starts at about 40 mm from the centre of the support element and terminates on its edge, namely at 95 mm from its centre.

The area 222 is bounded by three sides; two sides are straight and one side is curved; the curved side corresponds to a long section of the edge of the bottom side of the support element; the two straight sides extend in a radial direction and reach the edge of the bottom side of the support element; this area is wider in the peripheral zone than in the central zone.

The area 223 is bounded by four sides; three sides are straight and one side is curved; the curved side corresponds to a long section of the edge of the bottom side of the support element; two of the straight sides are parallel, extend in the radial direction and reach the edge of the bottom side of the support element; this area has substantially the same width both in the peripheral zone and in the central zone.

The area 224 is bounded by four sides; two sides are straight and two sides are curved; one of the curved sides corresponds to a long section of the edge of the bottom side of the support element; the other of the curved sides is a short circumferential section having its centre coinciding substantially with the axis of the support element; the two straight sides extend in the radial direction and reach the edge of the bottom side of the support element; this area is slightly wider in the peripheral zone than in the central zone.

The area 225 is bounded by four sides; three sides are straight and one side is curved; the curved side corresponds to a long section of the edge of the bottom side of the support element; two of the straight sides extend in the radial direction and reach the edge of the bottom side of the support element; this area is wider in the peripheral zone than in the central zone.

In the case of the examples 222, 223, 224 and 225, the depressed area starts at about 60 mm from the centre of the support element and terminates on its edge, namely at 95 mm from the centre thereof.

In all the examples according to Fig. 3 and Fig. 4, the depressed areas 22 of the support element 20 have a variable depth (the leaning of this term can be easily understood by considering Fig. 6); in these examples, their depth gradually increases, starting from zero and reaching a maximum along one edge of the said area; in Fig. 3 and Fig. 4 the side corresponding to the edge of the areas is shown as a continuous line and the sides corresponding to zero depth are shown as broken lines.

The edge of the depressed areas 22 is positioned and shaped so that the gas flows emerging from the passages 21 exert a thrust on the said edge.

In all the examples according to Fig. 3 and Fig. 4, the depth of the depressed areas 22 diminishes or increases (depending on which way they are viewed) in a tangential direction with respect to the axis of the support element.

In all the examples according to Fig. 3 and Fig. 4, the depth of the depressed areas 22 diminishes or increases (depending on which way they are viewed) in a radial direction with respect to the axis of the support element.

In general, the support system according to the present invention is intended for apparatus of the type designed to treat substrates and/or wafers and comprises:
- a fixed base element having a substantially flat surface in which a substantially cylindrical seat with a substantially flat bottom is formed; and
- a movable support element having a substantially disc-shaped form, being housed inside the seat, being designed to rotate about the axis of the seat and having a substantially flat upper side with at least one cavity for a substrate or wafer and a substantially flat bottom side;
one or more passages for one or more gas flows are envisaged; these passages emerge inside the seat in directions which are inclined and preferably skew with respect to the axis of the seat so as to lift and rotate the support element.

The effect of the gas flows will be illustrated below with the aid of Fig. 5.

A gas flow emerges from a passage 12 of the fixed base element 10 and strikes the bottom side of the movable support element 20; in this way, the gas flow imparts a continuous thrust to the element 20.

This thrust has a vertical component and a horizontal component; the vertical component tends to lift the element 20 and the horizontal component tends to move the element 20; the particular configuration of the support system (disc housed in a cylindrical seat) and the particular orientation of the gas flow (inclined with respect to the axis of the seat) are such that the element 20 performs a rotating movement. The two components are illustrated schematically in Fig. 5 by means of two arrows, but their length is not indicated; in fact, the ratio between the components depends on various factors, including the inclination of the passages 12 and the roughness of the surface of the bottom side of the element 20.

As is obvious, the solution according to the present invention is extremely simple from a constructional point of view, but allows optimum results to be obtained; the simplicity of a solution is always an advantage, but this is even more so in cases where this solution must be used in a complex and critical system, such as epitaxial reactors and RTP (Rapid Thermal Processing) apparatus.

Under operating conditions, when the gas flows out from the passages 12, a thin cylindrical chamber filled with gas is defined between the bottom side of the element 20 and the bottom of the seat 11; the pressure of the gas inside this chamber helps lift the element 20 imparting a thrust which is distributed in a fairly uniform manner over the whole of the bottom side of the element 20; therefore, under operating conditions, the element 20 rotates above a layer of gas and does not make contact with the bottom of the seat 11 (if the surfaces were to make contact with each other, small solid particles would form, these being very harmful in particular during epitaxial growth processes).

Initially, when the gas starts to flow out of the passages 12, the vertical component of the thrust generated by the gas flows causes rapid lifting of the element 20, while the horizontal component of the thrust causes slow movement of the element 20 owing to the inertia of the element 20; in this way, the bottom side of the element 20 does not make contact with the bottom of the seat 11 even under start-up conditions. Under the thrust of the gas flows, the element 20 gradually increases its rotational movement. This gradual acceleration eliminates completely the risk that the substrates or wafers may come out of the cavities of the support element during this step.

In the example of embodiment according to Fig. 1, acceleration times in the region of 1 minute were tested.

The minimum number of passages to be used in the support system according to the present invention is one; in this case, however, a suitable structure for guiding the rotation of the support element is required, as will be clarified more clearly below. From a theoretical point of view a maximum number of passages does not exist; in practice there should not be cases where more than eight passages are required. Therefore the passages may be one, two, three, four, five, six, seven or eight in number.

The passages emerge inside the seat; preferably, said passages emerge in a middle zone between the centre and the edge of the seat, in particular about halfway.

A constructionally simple, but equally efficient example consists of case where the passages are only two in number and are arranged in symmetrical positions with respect to the axis of the seat.

The inclination of the passages is a parameter of the system which must be carefully chosen; the choice of this parameter depends, among other things, on the roughness of the surface and the shaping of the bottom side of the support element; the inclination may be chosen in the range of between 30° and 60° (with respect to the vertical); if the surface of the side is smooth it is more appropriate to use inclinations of between 30° and 50°, while if the side is shaped it is more appropriate to use inclinations of between 40° and 60°.

Preferably, the size of the gap defined between the outer edge of the support element and the inner edge of the seat is small so that the gas emitted from the passages is prevented from flowing into said gap.

The support system according to the present invention has two normal operating conditions, namely when the support element is stationary and when the support element is in movement (at a substantially constant speed); there are also two transitory conditions, namely when the support element starts its movement and therefore accelerates, and when the support element finishes its movement and therefore decelerates.

It is advantageous for the support element to remain substantially inside the seat both when it is stationary and when it is in movement; its rotation is thus properly guided. Preferably, the upper side of the support element remains substantially aligned with the surface of the base element; in this case, the stream of the treatment gases flows perfectly over the upper side of the substrates or wafers and is not substantially disturbed by the support element and by the seat; moreover, since the support element is not inserted far inside the seat, it can be extracted more easily.

It is advantageous to provide in the seat an annular channel; in this way, the gas emitted from the passages tends to collect inside the annular channel and does not tend to flow inside the gap defined between the outer edge of the support element and the inner edge of the seat. The annular channel is formed preferably along the periphery of the bottom of the seat so that the gas exerts its action mainly on the bottom side of the support element.

From a constructional point of view it is advantageous if the various passages are branches of the same pipe; in this way, a single long hole is formed along the length of the base element, while the passages may be formed by providing short holes.

In order to ensure better guiding of the rotational movement of the support element, it is possible to envisage a pin and a corresponding hole; it is possible to provide the pin on the support element and the hole on the base element or the pin on the base element and the hole on the support element.

In order to obtain an even better guiding action, it is possible to use a more complex structure: a cylindrical protuberance with a cylindrical hole is provided in the centre of the seat of the base element, a cylindrical recess with a cylindrical pin is provided in the centre of the bottom side of the support element; the pin of the support element is inserted inside the hole of the base element and the protuberance of the base element is inserted inside the recess of the support element.

By means of inclined gas flows it is possible to obtain a good rotation of the support element; in order to improve the speed of rotation it is necessary to use a suitable support element which is shaped on the rear side.

The present invention also relates to such a support element shaped on the rear side.

In a support element shaped in accordance with the present invention, its bottom side is provided with depressed areas shaped so that the gas flows emerging from the passages exerts a thrust on these areas; this shaping is to be understood as being not only two-dimensional, but also three-dimensional.

These depressed areas are preferably all identical and arranged symmetrically with respect to the axis of the support element; this facilitates the design and construction of the support element without adversely affecting its performance.

By way of clarification, it may be said that the rear of the support element is shaped like a thin turbine vane; therefore, the gas flows are more effective in causing rotation of the support element.

Since the areas are depressed with respect to the surface of the support element, the overall dimensions of this element remain the same, as though said areas were not present.

The effect of the depressed areas is illustrated below with the aid of Fig. 6.

The gas flowing out of the passages 12, after striking the bottom side of the element 20, flows between the element 10 and the element 20; when the gas reaches the depressed area 22 it expands and strikes its walls; the latter are shaped so as to convert the thrust into rotation.

In the drawing according to Fig. 6, the gas follows the inclined profile of the bottom of the depressed area 22 and strikes the edge of the depressed area 22; in this way the gas transmits to the element 20 a continuous horizontal thrust which is converted into rotation of the element 20.

The depressed areas may have varying shapes; for the sake of simplicity, they may be bounded by only three or four sides; each of these sides may be straight or curved, as shown in Fig. 3 and Fig. 4.

The depressed areas may reach the edge of the bottom side of the support element; in this way, the thrust surface area is maximum.

One side of the depressed areas may coincide with a section of the edge of the bottom side of the support element; in this way, the gas expands freely after striking the depressed area and does not hinder the further rotation of the support element.

Preferably, the depressed areas have a variable depth; in this way it is possible to ensure an even more effective action of the gas flows on the support element.

The depth of the depressed areas may be reduced or increased in the radial direction with respect to the axis of the support element; in this way it is possible to control the distribution of the pressure of the gas underneath the bottom side of the support element.

The depth of the depressed areas may be reduced or increased in the tangential direction with respect to the axis of the support element; in this way, the gas follows properly the surface of the bottom side of the support element.

It is advantageous if the depressed areas have an edge (as shown in Fig. 6) positioned and shaped in such a way that the gas flows emerging from the passages exert a thrust thereon (all the examples of embodiment shown in Fig. 3 and Fig. 4 have this characteristic feature); a single edge for each depressed area is sufficient (all the examples of embodiment shown in Fig. 3 and Fig. 4 have this characteristic feature).

A support element defined as above is particularly suitable for acting also as a susceptor; in this case, it must be made of a conductor material; the material most commonly used for susceptors is graphite; since the support element according to the present invention is designed to be inserted inside a treatment chamber (where there are high temperatures and treatment gases), typically the graphite part must be provided with a protective layer of silicon carbide or tantalum carbide.

Owing to the fact that transmission members are not required for rotation of the support element, the support system according to the present invention is particularly suitable for performing the loading and unloading of the whole support element (together with the associated substrates or wafers) into and from the base element.

The system according to the present invention is particularly suitable for use as a support system for substrates in an epitaxial growth reactor.

The system according to the present invention may also be used as a support system for wafers in a high-temperature thermal treatment apparatus, for example an RTP apparatus; however, it must be said that in these apparatus heating is performed very rapidly and very quickly and therefore often the wafers are heated by means of lamps and often the wafer support element has a very small mass; moreover, high rotational speeds are required.

## Claims

1. Support system (1) for an apparatus of the type suitable to treat substrates and/or wafers, comprising:
- a fixed base element (10) having a substantially flat surface in which a substantially cylindrical seat (11) with a substantially flat bottom is formed,
- a movable support element (20) having a substantially disc-shaped form, being housed inside the seat (11), being able to rotate about the axis of the seat (11) and having a substantially flat upper side provided with at least one cavity (21) for a substrate or wafer and a substantially flat bottom side, and
- one or more passages (12) for one or more gas flows, said passages (12) emerging inside the seat (11) in directions which are inclined with respect to said axis, in such a way as to lift and rotate the support element (20);
**characterized in that** the bottom side of the support element (20) is provided with depressed areas (22) shaped so that the gas flows emerging from said passages (12) exert a thrust thereon.

2. System according to Claim 1, wherein the support element (20) is designed to remain substantially inside the seat (11) both when it is stationary and when it is in movement.

3. System according to Claim 1 or 2, wherein an annular channel (13) for collecting the gas emitted from the passages (12), is formed in the seat (11).

4. System according to Claim 1 or 2 or 3, wherein the passages (12) are branches of the same pipe (14).

5. System according to anyone of the preceding claims, wherein the passages (12) are only two and are arranged in symmetrical positions with respect to said axis.

6. System according to anyone of the preceding claims, wherein a pin and a corresponding hole are provided for guiding the rotation of the support element (20).

7. System according to Claim 6, wherein a cylindrical protuberance with a cylindrical hole is provided in the centre of the seat of the base element (10), in which a cylindrical recess with a cylindrical pin is provided in the centre of the bottom side of the support element (20) and in which the pin of the support element is inserted in the hole of the base element and the protuberance of the base element is inserted in the recess of the support element.

8. System according to anyone of the preceding claims , wherein said areas (22) are bounded by three or four sides.

9. System according to Claim 8, wherein said areas (22) have at least one straight side.

10. System according to Claim 8 or 9, wherein said areas (22) have at least one curved side.

11. System according to Claim 8 or 9 or 10, wherein said areas (22) have a variable depth.

12. System according to Claim 11, wherein the depth of said areas (22) diminishes or increases in the radial direction with respect to the axis of rotation.

13. System according to Claim 11 or 12, wherein the depth of said areas diminishes or increases in the tangential direction with respect to the axis of rotation.

14. System according to anyone of the preceding claims , wherein said areas (22) reach the edge of the bottom side of the support element (20).

15. System according to Claim 14, wherein one side of said areas (22) coincides with a section of the edge of the bottom side of the support element (20).

16. System according to anyone of the preceding claims, wherein said areas (22) have an edge, said edge being positioned and shaped in such a way that the gas flows emerging from the passages (12) exert a thrust on said edge.

17. System according to anyone of the preceding claims, wherein the support element (20) is able to act also, as a susceptor.

18. System according to anyone of the preceding claims, **characterized in that** it is suitable for loading/unloading of the support element (20) into/from the base element (10).

19. Reactor for epitaxial growth of semiconductor materials on substrates, **characterized in that** it comprises a support system for substrates according to anyone of Claims 1 to 18.

20. Apparatus for high-temperature thermal treatment of wafers, **characterized in that** it comprises a support system for wafers according to anyone of Claims 1 to 18.

21. System according to claim 1, wherein the passages (12) emerge inside the seat (11) in directions which are skew respect to axis of the seat (11).

22. System according to claim 1, wherein the areas (22) are all identical and arranged symmetrically with respect to axis of the seat (11).

23. System according to claim 2, wherein the upper side of the support element (20) remains substantially aligned with the surface of the base element (10).

## Patentansprüche

1. Stützsystem (1) für ein Gerät jener Bauart, die zum Behandeln von Substraten und/oder Wafern geeignet ist, mit:
- einem festen Basiselements (10), das eine im Wesentlichen ebene Fläche hat, in der ein im Wesentlichen zylindrischer Sitz (11) mit einem im Wesentlichen ebenen Boden ausgebildet ist,
- einem bewegbaren Stützelements (20), das eine im Wesentlichen scheibenförmige Gestalt hat, im Inneren des Sitzes (11) untergebracht ist, sich um die Achse des Sitzes (11) drehen kann und eine im Wesentlichen ebene obere Seite hat, die mit zumindest einem Hohlraum (21) für ein Substrat oder einen Wafer versehen ist und eine im Wesentlichen ebene Bodenseite hat, und
- einen oder mehrere Kanäle (12) für einen oder mehrere Gasströmungen, wobei die Kanäle (12) im Inneren des Sitzes (11) in Richtungen zusammenlaufen, die hinsichtlich der Achse geneigt sind, und zwar derart, dass das Stützelement (20) angehoben und gedreht wird;
**dadurch gekennzeichnet, dass** die Bodenseite des Stützelements (20) mit vertieften Bereichen (22) versehen ist, die so geformt sind, dass die aus den Kanälen (12) zusammenlaufenden Gasströmungen einen Schub darauf aufbringen.

2. System gemäß Anspruch 1, wobei das Stützelement (20) so ausgelegt ist, dass es im Wesentlichen im Inneren des Sitzes (11) verbleibt, sowohl wenn es stationär ist als auch wenn es in Bewegung ist.

3. System gemäß Anspruch 1 oder 2, wobei ein ringartiger Kanal (13) zum Sammeln des Gases, das aus den Kanälen (12) ausgelassen wird, in dem Sitz (11) ausgebildet ist.

4. System gemäß Anspruch 1 order 2 oder 3, wobei die Kanäle (12) von demselben Rohr (14) abzweigen.

5. System gemäß einem der vorherigen Ansprüche, wobei nur zwei Kanäle (12) vorgesehen sind und an symmetrischen Positionen hinsichtlich der Achse angeordnet sind.

6. System gemäß einem der vorherigen Ansprüche, wobei ein Stift und ein entsprechendes Loch zum Führen der Drehung des Stützelements (20) vorgesehen sind.

7. System gemäß Anspruch 6, wobei ein zylindrischer Vorsprung mit einem zylindrischen Loch in der Mitte des Sitzes des Basiselements (10) vorgesehen ist, in dem eine zylindrische Ausnehmung mit einem zylindrischen Stift in der Mitte der Bodenseite des Stützelements (20) vorgesehen ist, und in dem der Stift des Stützelements in dem Loch des Basiselements eingefügt ist und der Vorsprung des Basiselements in der Ausnehmung des Stützelements eingefügt ist.

8. System gemäß einem der vorherigen Ansprüche, wobei die Bereiche (22) an drei oder vier Seiten begrenzt sind.

9. System gemäß Anspruch 8, wobei die Bereiche (22) zumindest eine gerade Seite haben.

10. System gemäß Anspruch 8 oder 9, wobei die Bereiche (22) zumindest eine gekrümmte Seite haben.

11. System gemäß Anspruch 8 oder 9 oder 10, wobei die Bereiche (22) eine variable Tiefe haben.

12. System gemäß Anspruch 11, wobei die Tiefe der Bereiche (22) in der radialen Richtung hinsichtlich der Drehachse verkleinert oder vergrößert wird.

13. System gemäß Anspruch 11 oder 12, wobei die Tiefe der Bereiche in der tangentialen Richtung hinsichtlich der Drehachse verkleinert oder vergrößert wird.

14. System gemäß einem der vorherigen Ansprüche, wobei die Bereiche (22) die Kante der Bodenseite des Stützelements (20) erreichen.

15. System gemäß Anspruch 14, wobei eine Seite der Bereiche (22) mit einem Abschnitt der Kante der Bodenseite des Stützelements (20) übereinstimmt.

16. System gemäß einem der vorherigen Ansprüche, wobei die Bereiche (22) eine Kante haben, wobei die Kante derart positioniert und geformt ist, dass die von den Kanälen (12) zusammenlaufenden Gasströmungen einen Schub auf die Kante aufbringen.

17. System gemäß einem der vorherigen Ansprüche, wobei das Stützelement (20) außerdem als Suszeptor dient.

18. System gemäß einem der vorherigen Ansprüche, **dadurch gekennzeichnet, dass** es zum Laden/Entladen des Stützelements (20) in/aus dem Basiselement (10) geeignet ist.

19. Reaktor zum epitaktischen Aufbau von Halbleitermaterialien auf Substraten, **dadurch gekennzeichnet, dass** er ein Stützsystem für Substrate gemäß einem der Ansprüche 1 bis 18 aufweist.

20. Gerät für eine Hochtemperatur-Wärmebehandlung von Wafern, **dadurch gekennzeichnet, dass** es ein Stützsystem für Wafer gemäß einem der Ansprüche 1 bis 18 aufweist.

21. System gemäß Anspruch 1, wobei die Kanäle (12) im Inneren des Sitzes (11) in Richtungen zusammenlaufen, die hinsichtlich der Achse des Sitzes (11) schräg sind.

22. System gemäß Anspruch 1, wobei alle Bereiche (22) identisch und hinsichtlich der Achse des Sitzes (11) symmetrisch angeordnet sind.

23. System gemäß Anspruch 2, wobei die obere Seite des Stützelements (20) im Wesentlichen mit der Fläche des Basiselements (10) ausgerichtet bleibt.

## Revendications

1. Système de support (1) pour un appareil du type approprié pour traiter des substrats et/ou des plaquettes, comprenant :
un élément de base fixe (10) ayant une surface sensiblement plate dans laquelle un siège sensiblement cylindrique (11) avec un fond sensiblement plat est formé,
un élément de support mobile (20) ayant sensiblement une forme de disque, qui est logé à l'intérieur du siège (11), pouvant tourner autour de l'axe du siège (11) et ayant un côté supérieur sensiblement plat prévu avec au moins une cavité (21) pour un substrat ou une plaquette et un côté inférieur sensiblement plat, et
un ou plusieurs passages (12) pour un ou plusieurs écoulements de gaz, lesdits passages (12) sortant à l'intérieur du siège (11) dans des directions qui sont inclinées par rapport audit axe, afin de soulever et faire tourner l'élément de support (20) ;
**caractérisé en ce que** le côté inférieur de l'élément de support (20) est prévu avec des zones enfoncées (22) formées de sorte que les écoulements de gaz sortant desdits passages (12) y exercent une poussée.

2. Système selon la revendication 1, dans lequel l'élément de support (20) est conçu pour rester sensiblement à l'intérieur du siège (11), à la fois lorsqu'il est fixe et lorsqu'il est en mouvement.

3. Système selon la revendication 1 ou 2, dans lequel un canal annulaire (13) pour collecter le gaz émis à partir des passages (12), est formé dans le siège (11).

4. Système selon la revendication 1 ou 2 ou 3, dans lequel les passages (12) sont des ramifications du même tuyau (14).

5. Système selon l'une quelconque des revendications précédentes, dans lequel les passages (12) ne sont que deux et sont agencés dans des positions symétriques par rapport audit axe.

6. Système selon l'une quelconque des revendications précédentes, dans lequel une broche et un trou correspondant sont prévus pour guider la rotation de l'élément de support (20).

7. Système selon la revendication 6, dans lequel une protubérance cylindrique avec un trou cylindrique est prévue au centre du siège de l'élément de base (10), dans lequel un évidement cylindrique avec une broche cylindrique est prévu au centre du côté inférieur de l'élément de support (20) et dans lequel la broche de l'élément de support est insérée dans le trou de l'élément de base et la protubérance de l'élément de base est insérée dans l'évidement de l'élément de support.

8. Système selon l'une quelconque des revendications précédentes, dans lequel lesdites zones (22) sont délimitées par trois ou quatre côtés.

9. Système selon la revendication 8, dans lequel lesdites zones (22) ont au moins un côté droit.

10. Système selon la revendication 8 ou 9, dans lequel lesdites zones (22) ont au moins un côté incurvé.

11. Système selon la revendication 8 ou 9 ou 10, dans lequel lesdites zones (22) ont une profondeur variable.

12. Système selon la revendication 11, dans lequel la profondeur desdites zones (22) diminue ou augmente dans la direction radiale par rapport à l'axe de rotation.

13. Système selon la revendication 11 ou 12, dans lequel la profondeur desdites zones diminue ou augmente dans la direction tangentielle par rapport à l'axe de rotation.

14. Système selon l'une quelconque des revendications précédentes, dans lequel lesdites zones (22) atteignent le bord du côté inférieur de l'élément de support (20).

15. Système selon la revendication 14, dans lequel un côté desdites zones (22) coïncide avec une section du bord du côté inférieur de l'élément de support (20).

16. Système selon l'une quelconque des revendications précédentes, dans lequel lesdites zones (22) ont un bord, ledit bord étant positionné et formé de sorte que les écoulements de gaz sortant des passages (12) exercent une poussée sur ledit bord.

17. Système selon l'une quelconque des revendications précédentes, dans lequel l'élément de support (20) peut également servir de suscepteur.

18. Système selon l'une quelconque des revendications précédentes, **caractérisé en ce qu'**il est approprié pour charger/décharger l'élément de support (20) dans/de l'élément de base (10).

19. Réacteur pour la croissance épitaxiale des matériaux semiconducteurs sur des substrats, **caractérisé en ce qu'**il comprend un système de support pour substrats selon l'une quelconque des revendications 1 à 18.

20. Appareil pour le traitement à haute température des plaquettes, **caractérisé en ce qu'**il comprend un système de support pour plaquettes selon l'une quelconque des revendications 1 à 18.

21. Système selon la revendication 1, dans lequel les passages (12) sortent à l'intérieur du siège (11) dans des directions qui sont inclinées par rapport à l'axe du siège (11).

22. Système selon la revendication 1, dans lequel les zones (22) sont toutes identiques et agencées symétriquement par rapport à l'axe dudit siège (11).

23. Système selon la revendication 2, dans lequel le côté supérieur de l'élément de support (20) reste sensiblement aligné avec la surface de l'élément de base (10).
